# EUROPEAN PATENT APPLICATION

(11) **EP 1 732 142 A1**
(43) Date of publication of application: **13.12.2006**
(21) Application number: 05105081.3
(22) Date of filing: 09.06.2005
(51) Int. Cl.: H01L 31/068

(54) **Si solar cell and its manufacturing method**

(71) Applicant: Shell Solar GmbH, 81739 München (DE)
(72) Inventor: Froitzheim, Armin, 81739 München (DE); Münzer, Adolf, 85716 Unterschleissheim (DE)
(74) Representative: Rau, Manfred

(57) **Abstract**

A solar cell comprising a silicon body layer of n-type bulk doping having a front side and a rear side; a non-alloyed p-type doped region at the rear side of the body layer and forming a p/n-junction therewith; a rear side contact in electrical connection with the p-type doped region; and a front side contact in electrical connection with the n-type silicon body layer, and a method of manufacturing such a solar cell.

## Description

### Field of the Invention

The present invention relates to a solar cell and to a method of manufacturing a solar cell.

### Background of the Invention

Conventional silicon (Si) based solar cells comprise a base layer of crystalline Si doped with boron. At the side facing the sun during normal operation (the front side), an n-doped layer is provided e.g. by diffusion of phosphorous into the base layer. This so-called emitter layer forms a p/n-junction with the p-doped base layer. Front and rear side contacts are arranged that are in electrical connection with the n-doped layer and the p-doped base layer, respectively, to withdraw a photocurrent from both sides of the p/n-junction.

A known problem in such solar cells is degradation of the boron doped base layer, which is also referred to as light induced degradation (LID). The degradation adversely affects the minority carrier lifetime, i.e. electron lifetime in the boron (p) doped base layer, and is observed in both monocrystalline as well as in multi- or polycrystalline materials.

Research efforts have been directed in the past towards understanding the mechanisms underlying the degradation. The degradation is generally attributed to the formation of boron- and oxygen related defects under illumination, or minority carrier injection in the dark, although the precise mechanism is not yet fully understood.

Degradation of minority carrier lifetime impairs the efficiency of the solar cell, so one of the prime parameters of such solar cells is subject to degradation.

Several ways have been explored to circumvent this problem. For example, it has been proposed to use gallium (Ga) instead of boron as dopant. However, although Ga doped Si shows a much better stability indeed, this is not seen as a practical alternative for commercial cell production as Ga-doped crystalline Silicon is much more difficult to grow in a Czochralski process due to a difference in segregation coefficients.

Another alternative that has been considered is to reverse the doping of the base layer and the front side emitter layer, so that an n-type base layer of Phosphorous doping is used, at the front side of which a p-doped emitter layer is provided that forms a p/n-junction with the base layer. In such a cell, the base layer shows much better stability than boron-doped base layers in conventional cells, however degradation mechanisms of the front surface passivation of the p-type front emitter are observed here.

It has further been proposed to arrange the p/n junction at the rear side of an n-type Silicon base layer, wherein the p/n-junction is formed by alloying Alumina with Silicon. Such cells have been disclosed in Cuevas et al., Proc. 3rd World Conference on Photovoltaic Energy Conversion, 2003, vol. 1, p. 963-966 and Schmiga et al., 19th European Photovoltaic Energy Conference, 7 June 2004. The efficiencies of such solar cells with Czochralski (Cz) silicon was however not higher than 15.8%, which is well below efficiencies of above 17% that are achieved with conventional cells made on the basis of a p-type Si body layer.

It is an object of the present invention to provide a new type of Si solar cell that shows improved stability and good efficiency.

### Summary of the Invention

To this end the invention provides a solar cell comprising
- a silicon body layer of n-type bulk doping having a front side and a rear side;
- a non-alloyed p-type doped region at the rear side of the body layer and forming a p/n-junction therewith;
- a rear side contact in electrical connection with the p-type doped region; and
- a front side contact in electrical connection with the n-type silicon body layer.

Applicant has found that by arranging a non-alloyed p-type doped region at the rear side of an n-type Silicon body layer, a rear junction solar cell is obtained that can achieve significantly higher efficiencies than known from cells based on an Al-Si alloy. Preferably, the non-alloyed p-type doped region is a doping region obtained by diffusion of a dopant into the base layer, in particular by diffusion from a p-type dopant from a liquid that is applied to the rear side. Preferably the p-type dopant is Boron, but other dopants are also possible.

Not using an Al alloy has the further advantage that an Al alloy is opaque, whereas a doping region as obtained by diffusion only without alloying is transparent. This allows in a special embodiment to allow a maximum of light to be received as well through the rear side, such as diffuse or reflected light. In principle only the rear contacts provide shading.

Furthermore, the use of n-type Si as body layer overcomes the degradation problem of conventional solar cells with a boron doped body layer, and at the same time the invention circumvents the use of a p-doped front layer that can degrade as well. The placement of the p/n-junction at the rear side of the cell has the further advantage that the photocurrent maximised since light cannot be unproductively absorbed in a front-side emitter, in particular in the so-called dead zone of such an emitter. This maximises in particular the contribution of short wavelength light to the photocurrent, because such light is predominantly absorbed close to the front side, whereas longer wavelength light penetrates deeper into the cell.

In fact, in principle no doping is required at the front side for a functioning cell, and in particular not in regions that are not covered by front contacts anyway.

Preferably, the cell further comprises a n+ doped region between the front contact and the n-type silicon body layer. Such n+ doped regions form a n+/n junction with the base layer underneath the front contacts, and thereby create a driving force for photogenerated minority carriers away from the front contact. This can also be referred to as creating a 'front surface field', using similar terminology as the well-known 'back surface field' created by a p+/p junction at the rear side of a conventional cell.

A further advantage of arranging an n+ doped region underneath the front contact is that a better electrical connection is obtained, in particular when screen-printed/fired front contacts are used. In this way a possible metal/semiconductor Schottky contact can be overcome by tunnelling.

In a particular embodiment the n+ doped region is a shallow n+ doped region. The term shallow can refer to a relatively light n+ doping and/or to a doping that does not extend very deep, such as less than 1 micrometer, into the body layer. A shallow doping is preferred for minimizing recombination at the front surface. The doping is preferably just sufficient for a good electrical contact with the front contact.

Typically, the front contact has a finger structure striking a compromise between minimum shading of the front surface and optimum withdrawal of photocurrent. The n+ doped region between the front contact and the body layer can extend over the entire or substantially all of the front surface, or it can only be arranged surrounding the front contact. In the latter case, the n+ doping on the front side suitably covers at the highest 200% of the front surface area that is covered by the front side contact, preferably at the highest 150%, more preferably 130% thereof. In this way, a selective front surface field can be obtained, wherein the n+ doping underneath the contacts can be chosen such that a sufficient front surface field is achieved and for good contacting is provided, but recombination at the front surface area not covered by the front contact can be minimized. It can however be desired to arrange a region at the front side, not covered by the front contact, with additional n-type doping, in particular at a level between that of the n+ region and that of the n-type Si body layer. This can be advantageous for example for optimum passivation of the front surface.

The solar cell further suitably comprises a passivation layer at the front side, in order to minimize recombination losses at the front surface. The layer can preferably for example be an oxide such as SiO₂, a nitride such as SiN, undoped amorphous silicon, or n+ doped amorphous silicon layer.

In a particular embodiment of the invention the rear contact of the solar cell covers only part of the rear side. In this way, less material such as Ag or Al is required for the contacts, which could have the shape of a finger structure. Moreover it can be arranged that light can also be received through the rear side.

In particular, the p-doped regions at the rear side can only be arranged between the rear-side contact and the n-doped body layer, i.e. immediately surrounding the rear side contacts but not in substantially all of the remaining area on the rear side that is not covered by the rear side contact. In this way recombination at the rear side can be minimized. The p-dopes region can cover for example 200% of the rear surface area that is covered by the rear contact, preferably at the highest 150%, more preferably 130% or less thereof. In a rear surface region between the p-doped region a weaker p-doping can be applied as well.

The invention further provides a method of manufacturing a solar cell, the method comprising
- providing a silicon body layer of n-type bulk doping and having a front side and a rear side;
- providing a non-alloyed p-type doped region at the rear side of the body layer so as to form a p/n-junction therewith, by applying a p-dopant containing liquid to the rear surface and allowing the p-dopant to diffuse into the body layer;
- providing a rear side contact in electrical connection with the p-doped region; and
- providing a front side contact in electrical connection with the n-type silicon body layer.

### Brief description of the Drawings

The invention will now be described in more detail and with reference to the accompanying drawings, wherein
Figure 1 shows schematically a first embodiment of a solar cell of the invention in cross-section;
Figure 2 shows schematically a top view of a finger contacting structure of a solar cell;
Figure 3 shows schematically a second embodiment of a solar cell of the invention in cross-section;
Figure 4 shows schematically a third embodiment of a solar cell of the invention in cross-section;
Figure 5 shows schematically a fourth embodiment of a solar cell of the invention in cross-section.
Figure 6 shows Internal quantum efficiency IQE as a function of wavelength λ in nm of an n-type solar cell with front p/n junction (curve a) and a conventional p-type (curve b) solar cell, respectively, and for the p-type cell also the for rear side illumination (curve c);
Figure 7 shows IQE of a front (curve a) and rear (curve b) junction n-type silicon solar cell;
Figure 8 shows IQE for cells according to the invention at three thicknesses, a) 150 µm, b) 200 µm, and c) 250 µm;
Figure 9 shows IQE of solar cells with a standard front surface field diffusion (curve a) and a shallow front surface field diffusion (curve b);
Figure 10 shows effective lifetime t_{eff} at an injection level of 10¹⁵.cm⁻³ excess charge carriers, measured on textured, both side phosphorous diffused, and SiN coated n-type silicon wafers before (wide bars) and after firing (narrow bars);
Figure 11 shows V_{oc} (closed squares) and J_{SC} (open circles) of solar cells processed in parallel to the lifetime samples from Fig. 10;
Figure 12 shows the Current-Voltage (I-V) characteristic of a large area (148.9 cm²) n-type solar cell according to the invention, fully screen-printed, provided with a shallow Front surface filed and SiN passivated; and
Figure 13 shows degradation of efficiency on a relative scale with respect to starting efficiency as a function of illumination time T for the cell of Figure 12 (curve a) and a standard p-type cell (curve b).
Where the same reference numerals are used in different Figures, they refer to the same or similar objects.

### Detailed Description of the Invention

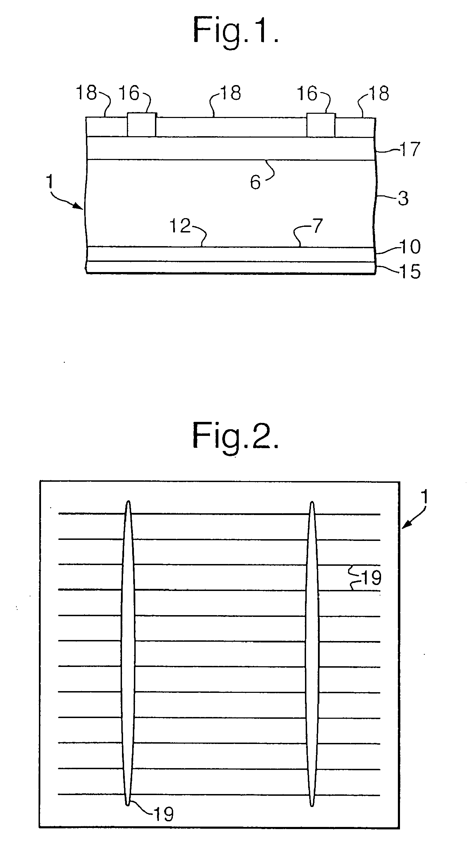

Reference is made to Figure 1 showing schematically a cross-section through a first embodiment of a solar cell 1 according to the invention. The solar cell 1 comprises
a silicon body layer 3 of n-type bulk doping having a front side 6 and a rear side 7. The silicon body layer 3 is made from crystalline silicon, and can be of the mono-, multi- or polycrystalline type. Preferably, Czochralski grown Silicon is used. The thickness of the body layer can be typically between 10 and 400 µm, suitably between 100 and 300 µm, preferably between 150-250 µm. A suitable dopant is for example phosphorous. The doping level is generally in the range of 10¹³-10¹⁸ atoms per cm³, typically in the order of 10¹⁵-10¹⁶. Suitably, the doping is such that a resistivity higher than 0.5 and lower than 150 Ohm.cm is obtained, preferably higher than 1 and lower than 20, more preferably lower than 10 Ohm.cm.

At the rear side 7, a p-doped layer 10 is arranged suitably such as discussed further below, and a p/n-junction 12 with the body layer is formed.

The doping level of the p-region can be higher that what one would use at a front contact, since at the rear side that is away from the light-receiving front side there most of the light has already been absorbed and there is less risk for recombination. A typical surface resistivity for the p-doped region in the present invention is in the range of 3 Ohm/sq or higher and 60 Ohm/sq or lower, preferably 5 Ohm/sq and higher, preferably 50 Ohm/sq and lower, such as 6 Ohm/sq. Sometimes a p-doped region in the doping levels required for such surface resistivities would is also referred to as a p+ region. Ohm/sq (equivalent to Ohm/square) is a commonly used parameter to characterized surface resistivity, which is also referred to as sheet resistivity. The depth of the p-emitter is typically in the range of 0.1-6 µm, when Boron diffusion from a liquid source is used typically 1-5 µm, often 1-3 µm.

A rear side contact 15 is arranged in electrical connection with the p-doped layer 10. The rear side contact is shown covering a large part or substantially all of the rear side of the cell.

At the front side 6, screen-printed front side contacts 16 are provided in electrical connection with the n-type silicon body layer. The front side contacts form part of a finger structure 19 such as sketched in top view in Figure 2 covering typically around 10% of the front service when screen printed contacts are used. The electrical connection is provided via a shallow n+ doped layer 17 on the front side 6, i.e. between the front contact and the n-type silicon body layer.

The n+ doped layer can have a surface resistivity of typically between 40 and 250 Ohm/sq, preferably 50 Ohm/sq and higher, more preferably 80 Ohm/sq and higher, in particular 120 Ohm/sq and higher, such as between 130 and 200 Ohm/sq. The n+ doping level is typically less than 4 µm deep, in particular 3 µm or less. The layer typically exhibits a concentration profile of n-dopant, which can be determined by SIMS, e.g. having a surface concentration of 6.10²¹ atoms/cm³ down to 10¹⁸ at 2-3 µm into the material.

The front surface is further provided with a passivation layer 18. The passivation layer can for example be an oxide such as SiO₂ a nitride such as SiN, undoped amorphous silicon, or mildly n+ doped amorphous silicon layer, which can be arranged using methods known in the art. It is a further advantage of the present invention that n or n+ doped layers can generally easier and better be passivated than p or p+ doped layers. An advantage of using SiN as passivation layer is that it has intrinsic charges.

Suitably further, an anti-reflection coating is provided as known in the art.

During normal operation of the solar cell 1 the front side 6 faces the sun and light is received through the area of the front surface that is not covered by the front contact 16. Light is absorbed predominantly in the n-doped body layer 3, and excess hole-electron pairs are created. The holes form minority charge carriers in the n-type material and travel towards the rear side over the p/n-junction 12 where they become majority carriers in the p-layer that are withdrawn at the rear side contact thereby providing photocurrent. The photogenerated excess electrons are prevented from diffusing to the front contacts by the field exerted by the n+/n junction leading between the body layer 3 and the p+ layer 18.

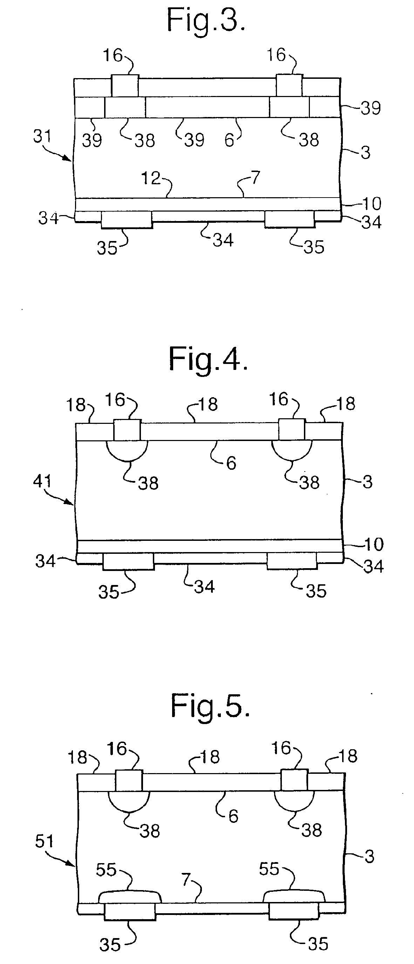

Reference is made to Figure 3 showing a second embodiment of a solar cell 31 according to the invention. Cell 31 differs from cell 1 of Figure 1 in that the rear contacts 35 are arranged in a finger structure covering only part of the rear side, e.g. similar to that of Figure 2. A typical coverage is in the range of 10-40% of the rear surface. Between the fingers a passivation layer 34 is arranged, for which the same type of layers can be used as for the front side. If the cell is suitably arranged for operation such that reflected or diffracted light is received at the rear side not facing the sun, additional photocurrent can be created by photons absorbed predominantly in the body layer 3 from the rear side.

A further difference with the cell of Figure 1 is the structured front surface field. Regions 38 of high n+ doping are arranged surrounding the front contacts 16, and regions 39 of weaker n+ doping in between front contact fingers, wherein the weaker n+ doping can be achieved by a doping concentration intermediate between that of the n-type body layer and that of the n+ doped regions 18, and/or in that regions 39 are shallower than regions 38.

Reference is made to Figure 4 showing a third embodiment of a solar cell 41 according to the invention. Cell 41 is similar to cell 31 of Figure 3, but in this case the front surface field is only provided by n+ doped regions 38, and the remainder of the front side of the body layer 3 is not provided with further doping in addition to the basic doping of the body layer.

Reference is made to Figure 5 showing a fourth embodiment of a solar cell 51 according to the invention. Cell 51 is similar to cell 41 of Figure 4, however the p doping at the rear side is only provided in regions 55 surrounding the rear contacts 35. In this way a maximum amount of, in particular short-wave, light that is received through the rear side of the cell can contribute to the generation of photocurrent. This embodiment allows an optimizing of the fractional rear surface area used for p-doped regions, independent of the area covered by rear side contacts. This is a further advantage over cells with Al alloyed rear contacts, in which the area of p-doped regions cannot be chosen larger than the area covered by opaque Aluminium, there Al serves both as dopant and provides the contacting structure.

Light that is received through the rear side can be reflected light or diffuse light.

The method of manufacturing a solar cell according to the invention will now be discussed.

A silicon body layer of n-type bulk doping, typically a wafer in <100> orientation that was sawed from a Cz grown and Phosphorous doped crystal, is provided. If desired a short, alkaline crystal-oriented etching can be used to texture the surface in order to improve the geometry of incidence of light in order to prevent reflection.

Providing a non-alloyed p-type doped region is done by a process which introduces dopant, preferably boron, only by diffusion into the rear surface of the body layer. Several processes for boron diffusion are known in the art, including diffusion from the gas phase or from liquid and solid phases applied to the surface. A preferred process is that known for the making of a p+ back surface field on the rear side of conventional p-type cells. This process as well as prior art is described in USA patents No. 5899704 and 6096968, which are incorporated by reference.

In general terms, a diffusion source layer that contains boron as a dopant is applied, e.g. spun, only onto the back of the n- doped silicon wafer. The diffusion source layer is one that contains boron and out of which the boron is thermally driven. The diffusion source layer is preferably applied by means of a boron doping resist. In addition to boron or its compounds, this resist contains powdery SiO₂ in a suspension. This doping resist is normally used for generating high dopings in power semiconductors. It may be applied in liquid form and may for example be spun on.

A suitable doping liquid is Siodop (TM) of Merck. Then the wafer is treated in an atmosphere that contains oxygen at a temperature of 900 to 1200 degree centigrade, preferably between 1000 and 1100 degree C, to generate an oxide layer and to drive in the dopant.

The further steps for providing the front side n+ layer and the front and rear side contacts for manufacturing a cell of the invention can also be conducted according to the steps disclosed in US 5899704 and 6096968, incorporated by reference.

So, after the p-doped region has been formed the oxide layer can be removed from the front surface, e.g. using HF, and optionally also the diffusion source layer and the oxide layer from the rear surface, followed by a diffusion of Phosphorous from the gas phase to form a front side n+ layer.

If a selective front surface field is to be arranged, a mask can be arranged on the front surface before removing the oxide layer, so that the oxide layer can be selectively etched away, followed by deep n-dopant (typically Phosphorous) diffusion into the body layer through the openings in the oxide layer. Then, the oxide layer can be fully removed, and if desired a shallow n-doping can be applied, this can be applied to the entire surface as the n+ regions will remain.

Similarly, if a structured p-emitter is to be provided as in Figure 5, a mask can be applied to the oxide on the rear side and those p-doped regions can be etched away that are not desired, leaving the desired emitter structure in place. The desired emitter structure can be precisely adjusted in this way.

If required after the formation of the n+ doped layer, a separation at the edge of the wafer may be performed, e.g. in a plasma.

Front and rear side contacts are preferably screen-printed in an industrial production process, and contacting is done at elevated temperatures. These can be 700-800 degree centigrade, but lower temperatures are also possible.

The squeegee paste for rear side contacts can contain silver particles, filler, oxides, and also an amount of Aluminium. It will be understood that at firing the paste in order to make electrical contact with the p region, a thin alloy might be formed at the interface between the p-doped region and the contact, but that the p-doped region itself towards the p/n junction is still a non-alloyed p-doped region. The front side contact is also suitably produced by screen printing and firing.

Passivation and antireflection coating can be applied using known methods, before or after contact formation.

Overall, a considerable advantage of the solar cell of the invention is that it can be produced with only minor adjustments of a known and industrially applied process for conventional p-type cells, and also using the advantages of that process as described in the cited US patents. Adjustments concern the adjustment of the doping to achieve desired sheet resistances.

For further illustration of the invention as a whole and of particular special advantageous features we will now discuss experimental data obtained from specific examples of solar cells according to the present invention.

Bare wafers have been measured by the El(y)mat-method in order to determine the diffusion length LD of charge carriers in the wafer. This method uses a HF-solution in order to passivate the surface and to form a Schottky barrier on the rear side oft the wafer. This contact is used to extract minority charge carriers, generated by a laser operating at 680 nm that illuminates the wafer from the front side with a spot size of about 1 mm². The extracted current can be used to determine LD.

In order to clarify whether phosphorous doped silicon (n-type) wafers do not show a degradation, and whether LD of the bulk silicon is superior to p-type boron doped silicon, El(y)mat measurements have been taken from a boron and phosphorous doped wafers before and after 50h illumination. Area averaged diffusion length LD on 125 x 125 mm² for various wafers was determined. It was found that the area average diffusion length decreased from 400 to 220 µm due to illumination of the boron wafer, but that the Phosphorous doped wafer had an stable LD of 440 µm before and after illumination. Taking into account that the wafer thickness is usually below 300 µm, the n-type wafers are suitable for fabricating a stable solar cells.

The final solar cells have been investigated by current-voltage (I-V) and internal quantum efficiency (IQE) measurements. The quantum efficiency analysis has been performed by illumination of the front and rear side, respectively.

Solar cells were manufactured from solar grade monocrystalline 125 mm x 125 mm Cz (Czochralski)- grown p and n-type silicon wafers as body layers, of about 250 µm thickness as sawn. After etch removal, texture etching was applied to the wafers. Three types of cells were manufactured and compared, conventional cells with p-doped body layer and front side p/n junction, n-type body layer cells with front p/n junction, and n-type body layer cells with rear p/n junction according to the invention.

For p-type doping of p- or n-type silicon wafers, to produce a back surface field (BSF) or a p-doped region, respectively, boron from a dopant source was diffused into the silicon.

Boron diffusion for BSF formation in p-type silicon suitably gives a sheet resistance of e.g. below 20 Ohm/sq. A front side emitter on an n-type Si suitably has a sheet resistance of 50 Ohm/sq or above, otherwise recombination losses are too high.

A phosphorous diffusion as used to arrange front side emitter for p-type silicon, and rear BSF for front contact n-type or front surface for n-type silicon. Again, the Phosphorous diffusion process is conducted differently for p- and n-type silicon, in order to adopt the diffusion doping to the application, e.g. above 50 Ohm/sq for emitter formation for p-type Si wafers and below 20 Ohm/sq for BSF formation for n-type Si wafers. For the FSF in a structure as depicted in Figure 1 a weaker/shallower doping of the layer 17 is used as compared to a BSF, typically 50 Ohm/sq and higher.

SiN was used in all cases as antireflection as well as surface passivation coating for n- and p-type silicon. Screen printing on the front and rear side is used for contact formation. The process sequences are in all cases similar except for the doping levels (sheet resistances) as discussed, and can be used on industrial scale.

First, the results for conventional p-type and front contact n-type cells will be discussed.

**Table I**

| | p-type | n-type front p/n junction | difference (%) |
|---|---|---|---|
| η (%) | 17.2 | 14.0 | - 18.7 |
| J_{SC} (mA/cm²) | 35.5 | 29.6 | - 16.6 |
| V_{OC} (mV) | 619 | 609 | - 1.6 |
| FF (%) | 78.3 | 77.4 | - 1.1 |

The standard process on p-type Si results in 17.2% efficiency, while the process on n-type Si results in 14.0% efficiency. The main difference is due to low short circuit current J_{SC}, e.g. only 29.6 mA/cm² for n-type compared to 35.5 mA/cm² for p-type silicon. The other parameters, open circuit voltage Voc and fill factor FF are reasonable.

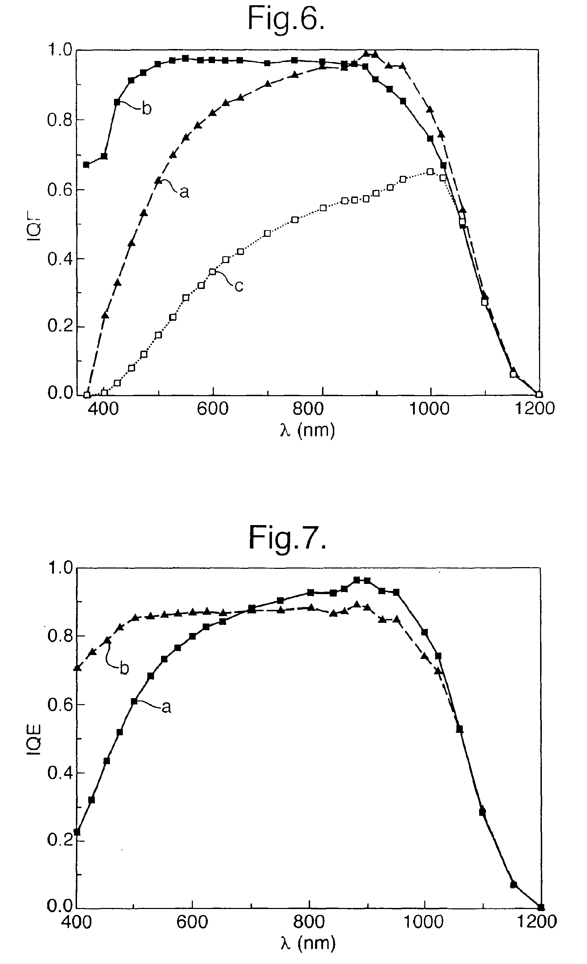

In order to investigate the origin of the low J_{SC}, Internal Quantum Efficiency (IQE) measurements have been performed on n- and p-type cells, respectively. Figure 6 show IQE measurements on conventional p-type silicon solar cells (curve b) and on n-type front junction solar cells (curve a) as a function of wavelength λ in nm. Additionally, a rear illuminated IQE measurement of the p-type solar cell is shown in curve c. The n-type silicon solar cell has a drastically reduced response in the short wavelength regime.

SIMS measurements on wafers that have been diffusion doped in parallel with the tested solar cells show a deep emitter profile of about 2 µm. As the passivation seems not to be very effective, most of the charge carriers generated in the emitter recombine rather than separate within the p/n-junction. Anyhow, the blue response is significantly enhanced compared to a rear illuminated p-type cell, as the recombination in the BSF is even more enhanced than in the boron emitter of n-type cells due to lower boron doping. The red (long wavelength) response of the IQE measurements indicates a higher diffusion length for n-type compared to p-type silicon, as already measured on the bare wafers. Therefore LD is not drastically reduced after all the process steps, especially after the boron diffusion.

Although reasonable results have been achieved by the boron front emitter approach it seems to be out of range to realise an n-type silicon solar cell with a similar efficiency as already achieved for p-type silicon.

Now the results obtained with solar cells according to the present invention will be discussed. The high LD observed in the Phosphorous doped wafers mainly supports this approach, as it is a pre-condition for rear junction solar cells. Additionally a uniform shallow boron emitter can be a challenge for boron diffusion with a dopant source. It is a further advantage of the present invention that this requirement for a higher efficient solar cell is avoided in a rear junction cell, as in this type of solar cell light doesn't have to transverse the deep and highly doped region. On the other hand, as will become apparent from the results below, the quality of the p/n junction obtained with an boron diffusion process is much better than can be achieved in Al-alloyed emitters, which can be highly inhomogeneous, spiking and exhibit partly shunting, and the exact doping is difficult to control.

In addition to I-V characteristics and IQE measurements as performed in section 3, quasi steady state lifetime measurements were performed on partly processed cells as described in a paper of Sinton et al, Proc. 25th IEEE PVSC, Washington 1996, p. 457.

The cell fabrication for rear junction n-type silicon is very similar to the cell fabrication of usual p-type solar cells described hereinbefore. The solar cell structure is shown in Fig. 1. The main difference compared to a p-type cell is, that the final solar cell has the p/n-junction on the rear side for n-type silicon solar cells. For the n-type structure the incoming light has to pass the phosphorous diffused front region, that acts as a front surface field in a similar manner, than the BSF in p-type cell. The advantage to the FSF is that it is not as highly doped (sheet resistance 50 Ohm/sq and above) as a usual BSF (sheet resistance 20 Ohm/sq and below), minimising recombination in this layer.

Table II summarises the results of non-optimised process conditions for n-type Si solar cells.

**Table II**

| | p-type | n-type rear p/n junction | diff. (%) |
|---|---|---|---|
| η (%) | 17.2 | 15.4 | - 10.5 |
| J_{SC} (mA/cm²) | 35.5 | 32.3 | - 9.0 |
| V_{OC} (mV) | 619 | 621 | + 0.0 |
| FF (%) | 78.3 | 76.9 | - 1.8 |

For comparison the I-V characteristics of the baseline p-type process and the deviation (in %) from n-to p-type is shown. The main difference compared to p-type is still J_{SC} (-10.5%), but this is now drastically reduced compared to the front junction approach (-18.7%). V_{OC} is nearly the same for both, n- and p-type and the filling factor FF is also already acceptable.

Fig. 7 shows IQE measurements on a front junction cell (curve a) and a rear junction cell (curve b) on the basis of an n-type body Si layer. The increase in the blue wavelength regime in curve b demonstrates the reduced recombination within the FSF compared to the recombination in the boron emitter of the front junction cell. This increased short wavelength response is responsible for the increase in J_{SC} from 29.6 mA/cm² to 32.3 mA/cm². The IQE characteristic of the rear junction cell shows a broad plateau between 500 and 900 nm at a value of slightly below 0.9 and is limited due to FSF recombination in the blue wavelength regime and due to finite absorption in combination with finite LD in the long wavelength regime. In contrast to usual front junction solar cells, IQE does not approach a collection efficiency of nearly 1. Reasons for this behaviour are a finite diffusion length compared to the wafer thickness, as the p/n junction is located on the rear side. Additionally, a not fully passivated front surface reduces IQE along the whole wavelength regime more dramatically than on front p/n junction cells, as the separation of the charge carriers occurs only on the rear side increasing recombination probability during the carrier diffusion phase.

As neither LD of the base material could be increased nor the optical confinement can be increased easily, the optimisation of the solar cell process was performed by varying the wafer thickness via etching, modifying the FSF via modification of the FSF diffusion, and modifying the surface passivation via variation of the SiN deposition conditions.

First, wafer thickness will be discussed. For a given base material quality, the ratio LD/w of diffusion length LD to the wafer thickness w, can be easily optimised by changing w without modifying any equipment in a cell line. Additionally, reducing w results also in reduced wafer costs. The boron diffusion doping process is compatible to wafer thicknesses down to 100 µm.

Table III summarises the characteristics of rear junction n-type solar cell according to the invention for wafers with a width w of 250 µm, 200 µm, and 150 µm, respectively. In this experiment etching was used to reduce silicon wafer thickness, instead of using different wire sawing parameters.

**Table III**

| | | | |
|---|---|---|---|
| thickness (µm) | 250 | 200 | 150 |
| η (%) | 15.4 | 16.3 | 16.2 |
| J_{SC} (mA/cm²) | 32.3 | 33.7 | 33.6 |
| V_{OC} (mV) | 621 | 630 | 627 |
| FF (%) | 76.9 | 76.8 | 76.9 |

Reducing w results in an overall increase in efficiency from 15.4% to 16.3% and 16.2% for 200 and 150 µm thick wafers. The gain in efficiency is due to an increased J_{SC} from 32.2 mA/cm² for 250 µm, to 33.7 mA/cm² for 200 µm thick wafers. Further reducing w does not influence J_{SC} significantly, e.g. J_{SC} is within the measurement accuracy the same for 200 µm and 150 µm thick wafers. Reducing w, also results in reduced absorption in the silicon wafer. Therefore an optimum between the amount of absorbed photons and collected charge carriers has to be found.

For processing thin wafers, of 200 µm and lower, the present invention has a particular over processes using Al alloying for emitter doping, namely that the alloying process results in bowing of the thin wafers which makes the production of modules from individual solar cells very difficult. This is prevented by not using alloying but only diffusion.

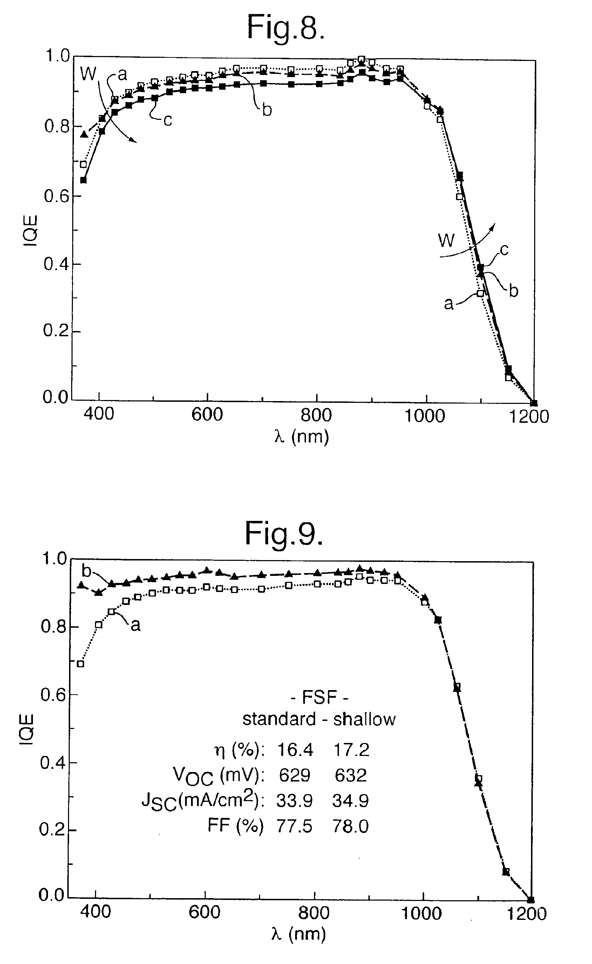

Fig. 8 shows IQE measurements on wafers of different thicknesses that have otherwise equally been processed. IQE is enhanced for wavelengths below about 950 nm due to an increased LD/w ratio, which increases charge carrier collection. All photons corresponding to wavelengths below 850 nm are absorbed in a 150 µm thick wafer. Therefore the greater LD/w is the more effective is the charge carrier collection on the rear side. For wavelengths greater than 1000 nm, the absorption of photons is reduced with decreased w, resulting in a reduced IQE for thinner wafers in the long wavelength regime.

V_{OC} has a flat maximum at 200 µm (630 mV) and is also nearly the same within process accuracy for 150 µm thick cells (627 mV), but definitely is increased compared to solar cells with 250 µm (621 mV). Therefore, the actual FSF and surface passivation seems to be good enough for wafer thicknesses of about 200 µm. With reduced wafer thickness, the FSF and surface passivation are more important due to a reduced importance of recombination within the bulk of the solar cell. For the actual FSF it is assumed, that the optimum wafer thickness is about 200 µm.

For even further optimisation of the cell efficiency, more precisely J_{SC} and V_{OC}, the FSF including the surface passivation can be optimised. The results of this optimisation will now be discussed, starting with the Front Surface Field. As demonstrated in Fig. 7 and 8, IQE is somewhat reduced in the blue wavelength regime due phosphorous diffusion on the front side of the wafer, resulting in an increased recombination in this highly doped layer. The reduction of the doping in the FSF would reduce recombination therein. Most favourable from this point of view would be even no extra front diffusion.

On the other hand it is desired to arrange front contacts by screen printing for an economic large-scale manufacturing process, an for forming a good electric contact a minimum doping level is preferred.

Figure 9 shows cell performance for an n+ layer of standard doping in curve a) (50 Ohm/sq), and a shallow n+ layer of 80 Ohm/sq in curve b). The term shallow is used to refer to doping of relatively low concentration and/or a doping that is not very deep, and the combined effect can suitably be characterised by a sheet resistance. Shallow doping (shallow diffusion) is referred to as doping of that results in a sheet resistance of 80 Ohm/sq and above.

The shallow front surface diffusion results in a solar cell with further increased blue response, as shown in Figure 9. Not only the absorption in the blue wavelength regime is increased, but also the IQE is increased up to 900 nm. Again, especially for a rear junction solar cell, the effect of reducing the front surface recombination is much more important than for a front junction solar cell. With reduced front surface doping, the efficiency further increased to above 17%.

Table IV shows a comparison of the standard p-type with the shallow rear junction emitter cell, and the difference between the two. For comparison the data for the standard rear junction emitter cell are also given.

**Table IV**

| | standard p-type cell | rear junction n-type cell with shallow FSF | diff. (%) | rear junction n-type cell with standard FSF |
|---|---|---|---|---|
| η (%) | 17.2 | 17.2 | 0 | 16.4 |
| J_{SC} (mA/cm²) | 35.5 | 34.9 | - 1.7 | 33.9 |
| V_{OC} (mV) | 619 | 632 | + 2.1 | 629 |
| FF (%) | 78.3 | 78.0 | - 0.4 | 77.5 |

The main gain in efficiency is again due to the increase in J_{SC}, while not compromising on V_{OC} and FF. With the shallow FSF approach in combination with the rear junction the efficiencies of standard p-type silicon is reached. Although the overall efficiency is the same for both materials, J_{SC} and V_{OC} differ somewhat. While J_{SC} is about 1.7% lower for the n-type cell according to the invention, V_{OC} is 2.1% higher for n-type material. Essential for the higher V_{OC} is the shallow FSF, compared to the relatively high doped emitter (below 50 Ohm/sq) of the standard p-type cell. The reduced J_{SC} is likely due to the rear junction concept, where a not perfect surface passivation as well as a finite LD/w ratio can limit the efficiency more drastically than in a front junction solar cell concept. Anyhow, this is compensated by higher v_{OC}, and it is clearly shown, that the rear junction concept on n-type silicon can lead to similar efficiencies as standard Shell Solar p-type front junction solar cells.

Yet a further improvement can be achieved by optimising the front surface passivation. The standard passivation by SiN on solar cells produced by Shell Solar GmbH is only moderate. If the surface passivation limits the solar cell efficiency and not LD, than a modified surface passivation should result in an additional increase in efficiency. For industrial solar cells it is mandatory that this surface passivation is stable, e.g. it won't be reduced by high temperature processes, such as firing the screen printed contacts and will not be subject to light induced degradation.

Three types of cells according to the invention have been tested, a cell with shallow n+ layer on the front side and a SiN passivation layer that was applied by a so-called LP (low pressure) process, hereafter referred to as SiN(No.1); a cell without shallow n+ layer and SiN passivation layer applied via PE-CVD [SiN(No.2); and a cell with shallow n+ layer and a PE-CVD generated SiN layer [SiN(No.3)].

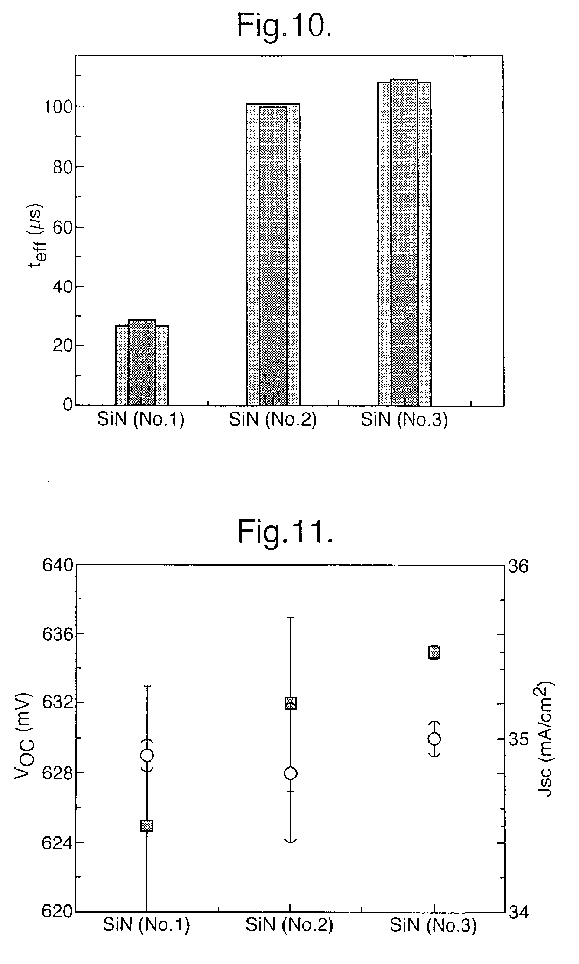

Fig. 10 shows the effective lifetime t_{eff} (excess charge carrier density 10¹⁵.cm⁻³) measured on textured, n-type wafers provided on both sides with a phosphorous diffused doping layer and SiN coating, that have had the same process steps, as the n-type shallow rear junction solar cell discussed above, except for the boron diffusion. The samples have been pulled through a firing furnace that is usually used for contact formation of screen-printed solar cells. As the n-type wafers are the same for all types of SiN depositions, it is assumed that the differences in effective lifetime reflects the surface passivation in a qualitative way. Interestingly, the life times, although not very high, are, within the measurement accuracy, the same before and after firing. Apparently the surface passivation is not impacted during firing.

The measurement of the open circuit voltage of cells according to the invention that were processed in parallel show the same tendency as the lifetime samples as shown in Figure 11, namely increases from No. 1 (V_{OC}: 625 mV, t_{eff} 29 µs) to No. 3 (V_{OC}: 635 mV, t_{eff} 109 µs) SiN deposition condition. The increase in V_{OC} clearly indicates the increased surface passivation. J_{SC} does not have a tendency; all variations are below 1%. SiN (No. 3) results not only in highest efficiencies, but also shows the narrowest distribution, as indicated by the error bars. Best efficiencies are expected from rear junction shallow emitter SiN (No. 3) processed solar cells.

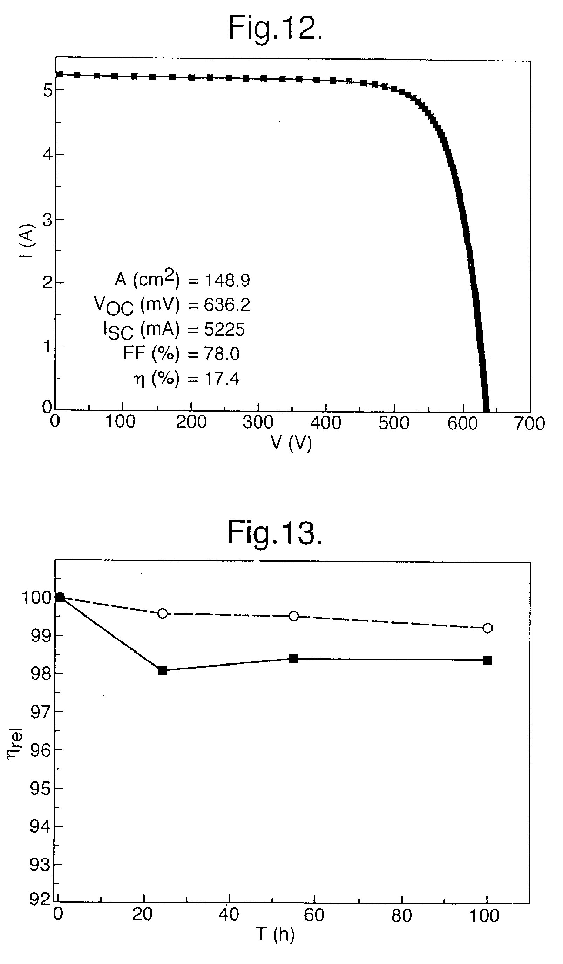

Fig. 12 shows the result of this type of solar cell, processed on large area (148 cm²), fully screen-printed. V_{OC}of 636 mV indicates a good surface passivation. The cells still show a somewhat low J_{SC} (35.1 mA/cm²). The fill factor was 78.0%, and an efficiency of 17.4% was measured.

Solar cells prepared from wafers with a thickness of 150 µm, do not show increased V_{OC} or J_{SC} values. Therefore it is concluded, that there might be room for further improvement of the surface passivation. However, if the efficiency is stable, especially regarding light induced degradation (LID), n-type solar cells have similar efficiencies than best p-type silicon solar cells and can compete even with the PEBSCO cell also developed at Shell Solar.

The stability of the solar cells according to the invention will now be discussed. As discussed hereinabove, n-type bare wafers do not show a measurable degradation. However, that does not exclude that there are other degradation mechanisms. It is known that the front surface of a n-type PERT cell strongly suffers from degradation with losses in V_{OC} up to 100 mV. It is concluded that the boron diffused front side in combination with its non-stable surface passivation is responsible for the LID effect in these n-type silicon solar cells. Therefore in the following section LID is investigated for n-type solar cells with rear junction geometry.

Fig. 13 shows the light induced degradation behaviour of rear junction the n-type silicon solar cell according to the invention, with SiN, and for comparison LID of a p-type silicon solar cell also processed at Shell Solar is shown. Both cells have a efficiency η of at least 17.2%. The p-type cell shows the behaviour as expected. The efficiency degrades up to 3% and saturates after about 24h. Heating the sample in ambient atmosphere for about 20 min at 200 °C completely recovers the efficiency to its initial value. The n-type cell with SiN (No. 3) passivation scheme degrades less than one percent, even after 100 h of illumination. Heating the sample after 100h of illumination reduces the LID effect to below 0.3% of its initial value. This is within the measurement accuracy of the measurement system, and is a very good indication for good long term stability.

The invention has proven the successful development of a large area (125 x 125 cm²) fully screen printed silicon solar cell on n-type wafers. The various optimisation steps allowed a final results that delivers n-type rear junction shallow front surface field SiN passivated solar cells with efficiencies in a narrow distribution around 17.4% (V_{OC}: 636.2 mV, J_{SC}: 35.1 mA/cm², FF: 78.0%).

In this way a number of major achievements have been made: The efficiency is at the same level as existing p-type Si technology, and generally significantly better than the best results for Cz wafer based cells using Al alloyed rear contacts reported before. The efficiency degradation of the new solar cells has been shown to be clearly below 1% after 100 h illumination. Further, the new cells can be manufactured on commercial scale using in principle the same process steps as they are already in use for commercial production of p-type solar cells at Shell Solar GmbH.

## Claims

1. A solar cell comprising
- a silicon body layer of n-type bulk doping having a front side and a rear side;
- a non-alloyed p-type doped region at the rear side of the body layer and forming a p/n-junction therewith;
- a rear side contact in electrical connection with the p-type doped region; and
- a front side contact in electrical connection with the n-type silicon body layer.

2. The solar cell according to claim 1, wherein the non-alloyed p-type doped region is a diffusion doped p-type region.

3. The solar cell according to claim 1, wherein the non-alloyed p-type doped region is a boron doped p-type region.

4. The solar cell according to any one of claims 1-3, further comprising an n+ doped region between the front contact and the n-type silicon body layer.

5. The solar cell according to claim 4, wherein the n+ doping on the front side covers at the highest 200% of the front surface area that is covered by the front side contact, preferably at the highest 150%, more preferably at the highest 130% thereof.

6. The solar cell according to claim 4 or 5, further comprising a region at the front side with an n-type doping between that of the n+ region and that of the n-type Si body layer.

7. The solar cell according to any one of claims 1-6, further comprising a passivation layer at the front side, preferably selected from the group consisting of an oxide such as SiO₂, a nitride such as SiN, undoped amorphous silicon, or n+ doped amorphous silicon layer.

8. The solar cell according to any one of claims 1-7, wherein the rear contact covers only part of the rear side.

9. The solar cell according to claim 8, wherein the p-doping at the rear side is only arranged in a region surrounding the rear-side contact.

10. The solar cell according to claim 8 or 9, wherein the rear side is arranged to receive light during normal operation.

11. A method of manufacturing a solar cell, in particular a solar cell according to any one of claims 1-10, the method comprising
- providing a silicon body layer of n-type bulk doping and having a front side and a rear side;
- providing a non-alloyed p-type doped region at the rear side of the body layer so as to form a p/n-junction therewith, by applying a p-dopant containing liquid to the rear surface and allowing the p-dopant to diffuse into the body layer;
- providing a rear side contact in electrical connection with the p-doped region; and
- providing a front side contact in electrical connection with the n-type silicon body layer.

12. The method according to claim 11, wherein the step of providing a non-alloyed p-type doped region comprises applying a boron containing diffusion source layer to the rear side and thermally driving the boron into the body layer.

13. The method according to claim 11 or 12, further comprising a step of providing a n+ doped region at the front side of the body layer.

14. The method according to claim 13, wherein the n+ doped region is structured and comprised a region of high n+ doping at the locations of the front contact, and optionally a lower n-doped region at a location where no front contact is arranged.
